Europäisches Patentamt

European Patent Office

Office européen des brevets

(19)

(11) Veröffentlichungsnummer: **0 048 488**

**A1**

(12) # EUROPÄISCHE PATENTANMELDUNG

(21) Anmeldenummer: **81107537.3**

(22) Anmeldetag: **22.09.81**

(51) Int. Cl.³: **H 05 K 9/00**
**H 05 K 5/00**

(30) Priorität: **23.09.80 DE 3035872**

(43) Veröffentlichungstag der Anmeldung:
**31.03.82 Patentblatt 82/13**

(84) Benannte Vertragsstaaten:
**AT BE CH FR GB IT LI LU NL SE**

(71) Anmelder: **SIEMENS AKTIENGESELLSCHAFT Berlin
und München**
**Postfach 22 02 61**
**D-8000 München 22(DE)**

(72) Erfinder: **Edel, Bernhard**
**Silberblattstrasse 29**
**D-8000 München 70(DE)**

(54) Gehäuse aus Kunststoff.

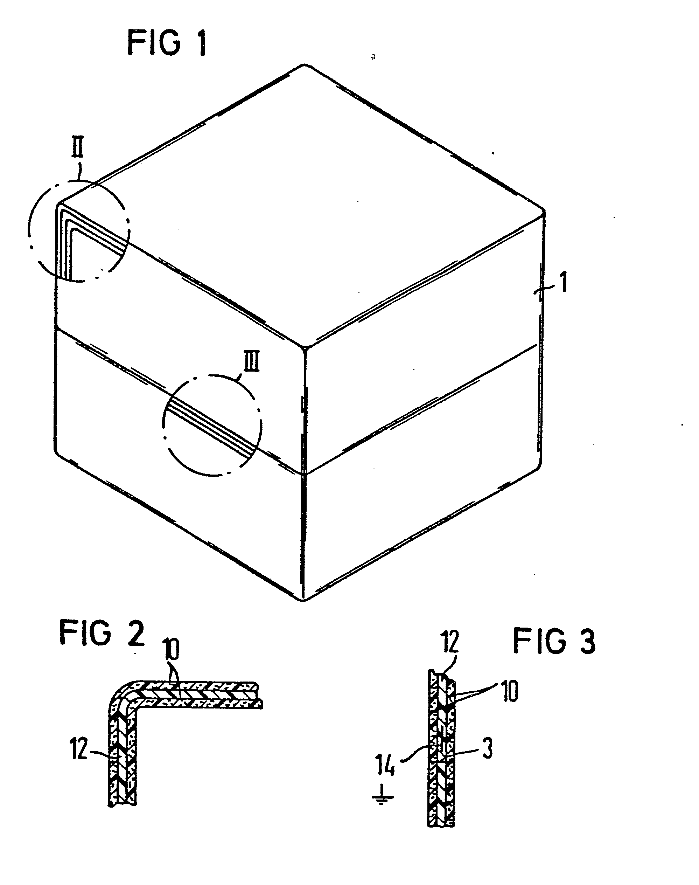

(57) Um die in einem Gehäuse aus Kunststoff angeordneten elektronischen Bausteine gegen elektrische und/oder magnetische Störfelder abzuschirmen, besteht das Gehäuse zumindest aus einer Schicht aus einem Kunststoff-Metallfließ-Laminat (12). Mit Hilfe des im Kunststoff eingebetteten Metallfliesses wird die Abschirmung der elektrischen und/oder magnetischen Störfelder erreicht. Es können dabei aber auch mehrere Schichten aus Metallfließ-Kunststoff-Laminaten und Mineralfließ-Kunststoff-Laminaten nebeneinander angeordnet werden. Zur Ableitung der Ladungen im Mineralfließ, kann dieses mit einem Erdkontakt verbunden sein (Fig. 3).

FIG 3

EP 0 048 488 A1

0048488

SIEMENS AKTIENGESELLSCHAFT      Unser Zeichen:
Berlin und München

80 P 2 0 7 5 · E

Gehäuse aus Kunststoff

Die Erfindung bezieht sich auf ein Gehäuse aus Kunststoff
zur Abschirmung elektrischer und/oder magnetischer Störfelder insbes. zur Aufnahme von elektronischen Bausteinen.

Bestimmte Geräte, z.B. Datensichtgeräte, müssen gegen elektrische und magnetische Störfelder abgeschirmt sein, die von
irgendwelchen Störquellen abgestrahlt werden. Dazu ist es bekannt, diese Geräte in Metallgehäusen unterzubringen oder
Kunststoffgehäuse vorzusehen, die mit einer Leitlacklackierung versehen sind. Es ist weiter bekannt, die abzuschirmenden Bausteine in zusätzlichen Metallteilen unterzubringen.
Ein Nachteil dieser Lösungen besteht darin, daß zusätzliche
Aufwendungen erforderlich sind, um die Abschirmung zu erreichen.

Die der Erfindung zugrundeliegende Aufgabe besteht darin,
ein Gehäuse aus Kunststoff derart aufzubauen, daß mit ihm
Abschirmung von elektrischen und/oder magnetischen Störfeldern möglich ist, ohne daß zusätzliche kostenverursachende Maßnahmen erforderlich wären. Diese Aufgabe wird bei
einem Gehäuse der eingangs angegebenen Art dadurch gelöst,
                                    einer Schicht mit
daß das Gehäuse zumindest aus/einem Laminat aus einem Kunststoff und einem Metallfließ besteht.

Aus der Zeitschrift Kunststoffe 68 (1978) 9, Seite 515 bis
519 ist unter dem Titel "Glasmatten-Polypropylen-Laminat"
ein Verbundwerkstoff auf Polypropylen-Basis mit einer durchgehenden Verstärkung aus Langfaserglasmatten berichtet.
Dier Verbundwerkstoff vereinigt die einfache Formgebungsmöglichkeit von Polypropylen mit der nach allen Richtungen

Il 1 Pe /15.9.1980

hin gleichbleibenden Versteifungswirkung von Glasmatten. Der Werkstoff kann auf einfache Weise mit Hilfe von Fließpressen geformt werden. Ein Gehäuse aus einem derart aufgebauten Glasmatten-Polypropylen-Laminat hat jedoch keine Abschirmwirkung gegenüber elektrischen oder magnetischen Störfeldern. Durch die Erfindung wird nun vorgeschlagen, in dem Laminat statt der Glasmatten ein Metallfließ vorzusehen. Damit wird eine Abschirmwirkung erreicht, ohne daß die Vorteile des Verbundwerkstoffes verloren gehen.

Das Metallfließ kann z.B. aus Stahlwelle bestehen. Durch Beschneiden der Kanten des Laminates wird das Metallfließ frei und kann kontaktiert werden. Zum Beispiel kann auch ein Erdkontakt in das Laminat eingelegt werden und damit statische Aufladungen abgeleitet werden.

Es ist möglich, mehrere Schichten von nebeneinanderliegenden Laminaten vorzusehen, von denen mindestens eine aus einem Kunststoff-Metallfließ-Laminat besteht, während die restlichen aus Mineralmatten-Kunststoff-Laminaten hergestellt sein können.

Soll ein Gehäuse, das aus derartigen Laminaten hergestellt ist, bei besonders hohen Frequenzen noch abschirmen, dann ist es zweckmäßig, das Metallfließ zusätzlich in Graphit einzutauchen.

Anhand eines Ausführungsbeispiels, das in den Figuren dargestellt ist, wird die Erfindung weiter erläutert. Es zeigen
Fig.1 eine Ansicht eines Gehäuses, das aus einem Kunststoff-Metallfließ-Laminat hergestellt ist,
Fig.2 ein Ausschnitt aus dem Gehäuse, bei der zur Darstellung des Schichtenaufbaus das Gehäuse aufgebrochen ist,

Fig.3 die Aufeinanderfolge der einzelnen Schichten an einer Schnittstelle, bei der auch ein Erdkontakt eingefügt ist.

Figur 1 zeigt ein Gehäuse 1, das aus dem Kunststoff-Metallfließ-Laminat aufgebaut sein soll. In der Figur 2 ist ein Abschnitt II der Figur 1 dargestellt und zwar ein Eckbereich, der aufgebrochen ist, um die aufeinanderfolge der einzelnen Schichten darzustellen. Im Ausführungsbeispiel folgt auf ein Kunststoff-Mineralfließ-Laminat 10 ein Kunststoff-Metallfließ-Laminat 12 und dann wieder ein Kunststoff-Mineralfließ-Laminat 10. Das Laminat kann dabei ein Polypropylen-Laminat sein, das ein Mineralfließ bzw. ein Metall-fließ enthält. Das Metallfließ kann z.B. aus Stahlwolle bestehen. Die Lage des Kunststoff-Metallfließ-Laminates kann an beliebiger Stelle angeordnet sein, es kann mittig, außen oder innen liegen. Zweckmäßig ist es jedoch, für hohe Frequenzen das Metallfließ zusätzlich in Graphit einzutauchen, bevor es mit Polypropylen zu einem Laminat verarbeitet wird.

Figur 3 zeigt die Draufsicht auf eine Kante an der Stelle III der Figur 1. Es ist wieder die Aufeinanderfolge der einzelnen Laminate gezeigt, wobei wie in Figur 2 dargestellt, das Metallfließ-Laminat 12 zwischen zwei Mineralfließ-Laminaten 10 angeordnet ist. Da im Bereich der Kante die einzelnen Laminate frei liegen, ist es möglich, an dieser Stelle das Metallfließ zu kontaktieren, z.B. das Metallfließ mit Erde zu verbinden. Es ist aber auch möglich, daß der Kontakt für Erde bereits beim Herstellvorgang in das Metallfließ eingelegt wird.

5 Patentansprüche
3 Figuren

Patentansprüche

1. Gehäuse aus Kunststoff zur Abschirmung elektrischer und/oder magnetischer Störfelder, insbesondere zur Aufnahme von elektronischen Bausteinen, d a d u r c h g e k e n n z e i c h n e t, daß das Gehäuse (1) zumindest aus/einem Laminat aus einem Kunststoff und einem Metallfließ besteht. einer Schicht mit

2. Gehäuse nach Anspruch 1, d a d u r c h g e k e n n - z e i c h n e t, daß das Metallfließ aus Stahlwolle besteht.

3. Gehäuse nach Anspruch 1 oder 2, g e k e n n z e i c h - n e t durch mehrere Schichten nebeneinanderliegender Laminate, von denen mindestens eines aus einem Kunststoff-Metallfließ-Laminat (12), die übrigen aus Mineralplatten-Kunststoff-Laminaten (10) bestehen.

4. Gehäuse nach einem der vorhergehenden Ansprüche, d a - d u rc h g e k e n n z e i c h n e t, daß das Metallfließ mit einem Erdkontakt (14) verbunden ist.

5. Gehäuse nach einem der vorhergehenden Ansprüche, d a - d u r c h g e k e n n z e i c h n e t, daß das Metall-fließ vor der Herstellung des Laminates in Graphit einge-taucht wird.

FIG 1

FIG 2

FIG 3

0048488

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | GB - A - 2 027 278 (BURR-BROWN RESEARCH) <br> * Seite 1, Zeile 124 bis Seite 2, Zeile 125; Ansprüche; Abbildungen * <br> --- | 1,2 |
| X | FR - A - 2 347 854 (VIBRACHOC) <br> * Seite 2, Zeile 11 bis Seite 3, Zeile 3; Ansprüche * <br> --- | 1,2 |
| | FR - A - 2 390 463 (IBM) <br> * Ansprüche * <br> & DE - A - 2 819 377 <br> --- | 1,4 |
| | US - A - 4 012 089 (SECRETARY OF THE U.S. NAVY) <br> * Spalte 3, Zeilen 9-21; Abbildung 3 * <br> --- | 1 |
| | DE - B - 2 348 687 (SIEMENS) <br> * Ansprüche; Abbildungen * <br> --- | 1 |
| | DE - A - 2 350 158 (MITSUBISHI) <br> * Ansprüche * <br> --------- | 1 |

**KLASSIFIKATION DER ANMELDUNG (Int. Cl.³)**

H 05 K 9/00
H 05 K 5/00

**RECHERCHIERTE SACHGEBIETE (Int. Cl.³)**

H 05 K 5/00
5/02
9/00

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 08.01.1982 | GORUN |